# EUROPEAN PATENT APPLICATION

(11) **EP 4 340 048 A1**
(43) Date of publication of application: **20.03.2024**
(21) Application number: 22195897.8
(22) Date of filing: 15.09.2022
(51) Int. Cl.: H01L 31/048, H01L 31/054

(54) **FRONT PANE FOR A PHOTOVOLTAIC MODULE**

(71) Applicant: Grenzebach Envelon GmbH, 86663 Asbach-Bäumenheim, Hamlar (DE)
(72) Inventor: Wenninger, Egbert, 86663 Asbach Baeumenheim, Hamlar (DE); Becker, Thilo, 86663 Asbach Baeumenheim, Hamlar (DE); Merklein, Hans-Peter, 86663 Asbach Baeumenheim, Hamlar (DE); Oertel, Mike, 74523 Schwäbisch Hall (DE); Röder, Thorsten, 52393 Hürtgenwald (DE); Wegener, Ingo, 86150 Augsburg (DE)
(74) Representative: WBH Wachenhausen Patentanwälte PartG mbB

(57) **Abstract**

The present invention relates to a front pane (10) for a photovoltaic module. The front pane (10) comprises a translucent, in particular transparent, pane (22) with a front side facing outwardly in the photovoltaic module and a back side facing towards a photovoltaic layer (16) of the photovoltaic module. The front pane (10) further comprises an interference filter configured to provide a base color for the front pane (10), the interference filter comprising at least one interference layer (24). In addition, the front pane (10) comprises a colorant layer (20) configured to provide a color modification for the front pane (10) so that an overall color of the front pane (10) is different to the base color and a color of the colorant layer (20). The present invention further relates to a photovoltaic module with such a front pane (10).

## Description

### Technical Field

The present disclosure relates to a front pane for a photovoltaic module and to a photovoltaic module.

### Prior Art

Sustainable generation of electrical energy is required for achieving a carbon emission free economy. To that end, solar or wind energy may be harnessed to create electricity. For example, wind turbines may be driven by wind, thus creating electricity. Photovoltaic devices may convert light emitted from the sun into electricity with semiconducting materials that exhibit a photovoltaic effect.

However, for that purpose, photovoltaic devices need exposure to the sun and sufficient space for their erection. In a rural setting, sufficient open space may be available for erecting photovoltaic devices. In rural settings, electric energy demand may be low, though. Transporting electric energy over longer distances to more urban areas, where there may be a higher demand for the harvested energy, requires additional infrastructure investments, for example in the form of electric lines. Moreover, transporting energy over longer distances results in losses. Overall efficiency may thus be low, despite using a favorable site for the photovoltaic device. Alternatively, photovoltaic devices can be installed in urban settings. However, in densely populated areas, open spaces might be too valuable for installing photovoltaic devices. For example, most cities only have little free space, such as parks and squares, that are required for recreational purposes of the population and are thus not available for the erection of photovoltaic devices.

A further option is to install or integrate photovoltaic devices on or in buildings. However, the photovoltaic devices might negatively impact the exterior design and appearance of the building. Externally installed photovoltaic devices may result in an unsightly outer contour, thus having low acceptance with architects or even violating city standards. Building integrated photovoltaic devices may limit a color scheme for the outer appearance of the building. Moreover, if coloring the photovoltaic device to blend in with other materials of the building and/or to satisfy the requirements of an architect, a photovoltaic efficiency might be impaired as a result.

EP 3 361 514 B1 describes a front pane for a photovoltaic module. A front side of a transparent pane comprises recesses with protrusion in between, wherein the recesses are at least partially filled with a layer of colorant. Parts of the transparent pane remain uncoated so that the colorant is not continuous. An interference filter may be provided to a rear side of the front pane, which enhances a color impression for a viewer. Such an interference filter increases costs and decreases transmissivity of the front pane.

WO 2014/045144 A1 describes an interference filter with an orange color of reflection suitable for roof-integration of solar energy systems.

WO 2015/009377 A1 describes a method of forming durable glass enamel.

### Summary of the Invention

A first aspect of the invention relates to a front pane of a photovoltaic module. The front pane may form the cover of the photovoltaic module. The photovoltaic module may comprise a photovoltaic layer, for example formed by photovoltaic cells and/or a thin layer having a photovoltaic effect. The photovoltaic module may be configured to convert light into electricity. The photovoltaic module may comprise electrical contacts, a power conversion device, a control device and/or other parts. The photovoltaic module may comprise a device for cleaning an exterior side of the front pane. The front pane may form a cover for the photovoltaic layer. The front pane may be configured to protect the photovoltaic layer from the environment and/or to structurally support the photovoltaic layer. The front pane may be configured to at least allow a certain spectrum of light to reach the photovoltaic layer for the generation of electricity. The front pane may have a front side forming an exterior of the photovoltaic module. The front pane may have a back side facing towards the photovoltaic layer in the photovoltaic module.

The front pane comprises a translucent, in particular transparent, pane. The pane may be formed as a flat sheet. An extension of the front pane along its front and back side may be several magnitudes larger than an extension between the front side and back side. The front pane may thus be very thin when compared to its lateral extension. The pane may, for example, have a planar shape or may be curved. For example, the translucent pane may be made out of glass, in particular silica glass, or plastic. The translucent pane may have multiple translucent layers or just one translucent layer. The translucent pane has a front side facing outwardly in the photovoltaic module. The front side of the translucent pane may be facing towards an exterior or may even form an exterior side of the photovoltaic module. The translucent pane has a back side facing towards a photovoltaic layer in the photovoltaic module. The back side may be arranged opposite the front side. The translucent pane may allow transmission of light from the front side to its back side, for example in a bandwidth causing the photovoltaic effect in the photovoltaic layer. The translucent pane may form a substrate of the front pane. Other parts of the front pane may be supported by the translucent pane.

The front pane has an interference filter. The interference filter may be configured to provide a base color for the front pane. An interference filter may be an optical filter that reflects one or more spectral bands or lines and transmits others, while maintaining nearly zero absorption for all wavelengths of interest. For example, absorption may be less than 2%, less than 1 %, less than 0,5%, less than 0,1% or even less than 0,01%. An interference filter may be high-pass, low-pass, bandpass, or band-rejection. The interference filter may use an interference effect to cause reflection and/or filtering of certain wavelengths of light. Differences in the index of refraction, for example at the boundary of certain layers, may cause a difference in path lengths and thus the interference effect responsible for filtering. Material on either side of the interference filter may have a different index of refraction for light.

The interference filter comprises at least one interference layer. The at least one interference layer is different to the translucent pane and/or a colorant layer. For example, the at least one interference layer may be a dielectric layer. The at least one interference layer may be made from an oxide or nitride, such as titanium oxide or silica nitride. For example, any interference layer of the interference filter may have a thickness with an order of magnitude similar to a wavelength of light spectra to be filtered. For example, the at least one interference layer may be glued or otherwise attached to the translucent pane. Alternatively, the at least one interference layer may be formed by a dried liquid. For example, the liquid may be sprayed or rolled onto the translucent pane. The at least one interference layer may be manufactured in a sputtering process, resulting in a very thin layer. The interference filter and its layers may be different to other layers, such as the colorant layer and/or the translucent pane.

The base color may be dependent on the spectrum of light filtered by the interference filter. The base color may be dependent on the angle from which the front pane is viewed and/or at which angle light falls onto the interference filter. Moreover, the base color may also be dependent on the spectrum of light falling onto the front pane. The base color may thus be a function of these factors rather than being defined by a uniform spectrum of light reflected and/or absorbed. The interference filter may provide the base color with a high level of transmissivity, resulting in the photovoltaic module having a high degree of efficiency. The interference filter may have a front side and a back side. The translucent pane and the at least one interference layer may together define the base color and/or form the interference filter. Any interference layer may have a front side and a back side.

The front pane comprises a colorant layer configured to provide a color modification for the front pane. For example, a color appearance of the front pane may be different to a front pane with just the interference filter without the colorant layer. The colorant layer may be configured to absorb light at a certain spectrum. The colorant layer may have a color different to the base color provided by the interference layer. The colorant layer may have a front side and a back side. The front side of the colorant layer may be facing towards an outer side of the photovoltaic module and the back side may be facing towards the photovoltaic layer. The colorant layer may be different to the translucent pane and/or the at least one interference layer. The colorant layer may have a color that is defined by an absorption and/or reflection of light spectra. For example, a color of the material of the colorant layer may be independent of a viewing angle and a light incident angle. At least one layer of the interference filter may be made from a material with a higher transparency than the colorant layer. The interference filter may have a higher transparency than the colorant layer. For example, the colorant layer may not be completely opaque.

The colorant layer may, for example, not form a part of the interference filter. The colorant layer may be a film, in particular a plastic film, that is colored or has colored particle in a matrix, in particular a translucent matrix. The colorant layer may be configured as an enamel layer, in particular a glass enamel layer. For example, particles dispersed in liquid may be applied to the translucent pane and sintered to create the colorant layer. As another example, the colorant layer may be manufactured from a liquid using an UV-hardening. The colorant layer may also be some form of glass layer. The hardening process of the colorant layer may bond the colorant layer to an adjacent layer, such as the translucent pane and/or the at least one interference layer. The colorant layer may be manufactured from two components, for example pigments and glass particles. The base material for manufacturing the colorant layer may be some powder or powder in a solvent or liquid medium. The powder can be baked into the surface of another layer, such as the translucent layer. The colorant layer may be configured as a continuous layer. For example, the colorant layer may cover the whole front side or back side of an adjacent layer. Manufacturing of a continuous layer may be particular easy and cost-effective. For example, the colorant layer may also be formed by discrete sections, in particular arranged on another layer such as the translucent pane. For example, the colorant layer may be printed on the translucent pane. A resolution may be sufficiently high so that the colorant layer appears continuous from sufficiently far away, such as from 0,5 m, 1,0 m, 2,0 m or 5,0 m away. The discrete sections of the colorant layer may be completely opaque. Due to a spacing between the discrete sections, nevertheless light may pass through the colorant layer.

The color modification causes an overall color of the front pane to be different to the base color and a color of the colorant layer. For example, the color of the colorant layer may overlay the base color, resulting in a different color. For example, the colorant layer may absorb certain bandwidths of light, resulting in a different effect of the interference filter. The overall color may also be an addition of the base color of the interference filter and the color of the colorant layer. The overall color may correspond to a spectrum of light reflected by the front pane when subjected to light, for example due to light refraction and/or reflection. The overall color may have a certain spectral distribution. The overall color may be dependent on the angle of infalling light and/or on the angle from which the front pane is viewed. The overall color may also be dependent on the photovoltaic layer arranged behind the front pane in the photovoltaic module or may be independent thereof. The color modification may cause said dependency of the overall color on the angle of infalling light and/or on the angle from which the front pane is viewed to be modified as compared to just the interference filter, in particular having a reduced dependency on these angles. As such, the overall color may be more homogeneous with respect to view angles and/or a relative position of the sun, rendering the front pane more acceptable as an exterior for buildings. The saturation and/or brightness of the base color and a color of the colorant layer may change in opposite directions with changing viewing angles, leading to an overall more stable average saturation at different viewing angles. For example, the color saturation of the base color may decrease with increasing viewing angles, while the color saturation and/or brightness of the color modification may increase with increasing viewing angles. The saturation and/or brightness of the overall color of the front pane may thus be more stable at different viewing angles. The overall color may have a different spectral distribution and/or may have a different angle dependence, in particular a reduced angle dependency. Further, less light may be absorbed than just by providing a colorant layer on the front pane without an interference layer, when such a colorant layer is configured to provide a similar color without the interference filter as the overall color provided by the combination of the colorant layer and the interference filter. Overall efficiency may thus be higher since transmissivity of the front pane may be high. Further, the colorant layer may be chosen to absorb light at frequencies that cause no photovoltaic effect in the photovoltaic layer or that is only of minor relevancy for the generation of electricity by the photovoltaic module, also resulting in a high efficiency. Moreover, the combination of interference filter and colorant layer may provide a higher variety of overall colors for the front pane as compared to just using a colorant layer or an interference filter. The front pane thus provides a higher design freedom, which may be particular useful for photovoltaic modules integrated into buildings.

The front pane may consist of the layers described herein. The front pane may be free of other layers besides those described herein. For example, the front pane may consist of the translucent pane, the colorant layer and the interference filter, wherein the interference filter may comprise only one, two or more layers.

In an embodiment of the front pane according to the first aspect, the interference filter is configured as a multilayer filter. For example, the interference filter may have two or more interference layers. The filtering effect of an interference filter with a high number of layers may be strongly customized. An interference filter with a low number of layers may be very cost-effective. Manufacturing costs may be low in this case. The interference layer may comprise layers of different material. For example, at least two layers may be made from different materials. At least one interference layer may have a different index of refraction compared to the material on either side of it. At least two different interference layers of the interference filter may have a different index of refraction.

In an embodiment of the front pane according to the first aspect, at least one of the sides of the translucent pane has a structured surface. Such a structure may provide improved attachment of other layers on that surface. For example, the structured side may be guttered, contain recesses in regular as well as random intervals or have a particular rough surface, for example being rougher than the surface of a glass translucent pane normally manufactured in a float glass process. The structure may be introduced after manufacturing of the base translucent pane, for example by means of a laser or acid etching. The structure may also be introduced through so called patterned glass, where the glass surface is modified through mechanical indentation of the hot glass surface. The translucent pane may comprise several translucent layers. For example, the front most translucent layer may have a structured front side. Alternatively or additionally, the back most translucent layer may have a structured back side. A structured layer may be provided by means of an application process on a base translucent layer. The structured translucent layer may be made from a different material than the base layer. The structured side may be formed in an additive process.

For example, both sides of the translucent pane may be structured. The structured surface might reduce glare, for example by scattering reflected light. Further, the structured surface may reduce angle dependency of the overall color appearance, in particular if the at least one interference layer is arranged on the structured surface of the translucent pane. When the structured surface is the front surface of the translucent pane, light collection and thus efficiency of the photovoltaic module may be improved.

In an embodiment of the front pane according to the first aspect, at least one of the sides of the translucent pane has a flat surface. For example, the flat surface may be smoother than the structured surface. For example, the flat surface may be a smooth surface. The flat surface may be manufactured in a float glass process in which glass is formed on a bed of liquid metal, such as tin. Alternatively or additionally, the flat surface may be smoothed, for example by polishing. A smooth surface may be very cost-effective to manufacture since no additional manufacturing step may be required, in particular in case of the translucent pane being made from glass. Moreover, outer appearance of the front pane may be very uniform. When the flat surface is the front surface of the translucent pane, cleaning of the front pane may be easier and the front pane may be more resistant to soiling. Both sides of the translucent pane may be flat.

In an embodiment of the front pane according to the first aspect, the translucent pane is configured as a glass pane. For example, the translucent pane may be made from a silica glass or a non-silicate glass, such as from titanates. The glass pane may be a fully tempered or semi tempered glass. A tempered glass may be particular resilient. The translucent pane may be made from a single layer of material. The translucent pane may be made, for example, from a plastic material such as acryl. The glass pane may be tempered during the manufacturing of the front pane, in particular together with the colorant layer. For example, a base material for forming the colorant layer, such as a liquid with particles dispersed therein, may be heat-treated together with the glass pane. Such a heat treatment may temper the glass pane while also hardening the colorant layer, for example for forming an enamel layer as the colorant layer. Such a manufacturing process may be very efficient. For example, the glass pane may be semi tempered or not tempered at all when applying material forming the colorant layer and may be fully tempered in the front pane after the subsequent heat treatment.

In an embodiment of the front pane according to the first aspect, the translucent pane provides structural support for the front pane. For example, the translucent pane may be rigid and/or self-supporting. The translucent pane may be several millimeters thick, such as 1 to 12mm, more particular 2 to 6 mm. The other layers of the front pane may be limp and/or not self-supporting. The thickness of other layers and/or of overall the front pane may be low due to the structural support by the translucent pane. For example, the at least one interference layer may only be about 5 nm to 400 nm thick, more particular 20 to 250 nm.

In an embodiment of the front pane according to the first aspect, the translucent pane is essentially colorless. For example, the translucent pane can be completely see-through. The colorless translucent pane may result in a very efficient photovoltaic module, in particular if not absorbing any spectrum of light that causes the photovoltaic effect and/or that is visible to the human eye or just absorbing 0,01% to 7%, in particular 0,2% to 5%. The colorless translucent pane allows configuration of the overall color at least partially independent of the translucent pane.

In an embodiment of the front pane according to the first aspect, the colorant layer comprises colored particles, in particular colored inorganic particles. Using colored particles allows easy customization of the opaqueness of the colorant layer by setting an appropriate concentration. Inorganic particles may be particularly robust, for example able to withstand high temperatures. As such, the inorganic particles may be subjected to a heat based hardening and/or bonding process of the colorant layer. For example, the inorganic particles may be ceramic particles. The particles may be combined with glass frit and an organic solvent or carrier and/or modifiers to form an ink. That ink may be applied to the translucent pane and the organic parts can be evaporated and/or burned off while the glass frit and the particles are fused and bonded to the translucent pane. The colorant layer may comprise a matrix in addition to the colored particles. Alternatively, the colorant layer may consist of the colored particles. The colored particles and/or the glass frit may be fused to provide a homogeneous quasi-continuous colorant layer, for example to form a glass colorant layer. The colorant layer may also be discontinuous layer. For example, the colored particles may be arranged on another layer, such as the translucent pane, without a matrix. The colored particles may be at least partially spaced apart from each other to allow light to pass in between, either to form discrete sections of the colorant layer or within the colorant layer. The colored particles may be completely opaque. For example, the colored particles may be printed onto the translucent pane.

In an embodiment of the front pane according to the first aspect, the interference layer leads to an average transmissive loss between 1% and 25% of an incoming light spectrum, in particular between 3% and 15% of an incoming light spectrum. Alternatively or additionally, the colorant layer leads to an average transmissive loss between 2% and 60% of the incoming light spectrum, in particular between 5% and 45% of the incoming light spectrum. Such a configuration results in an efficient photovoltaic module that nevertheless has an outer appearance with a rich overall color. The loss may be unevenly distributed over the spectrum of the light. The loss may be evenly distributed over the spectrum of the light.

In an embodiment of the front pane according to the first aspect, the front pane comprises a lamination layer, in particular configured as a film. The lamination layer may provide and/or facilitate a bond between the front pane and the photovoltaic layer. The lamination layer may at least partially or fully encapsulate the photovoltaic layer, in particular together with a lamination layer of a back pane of the photovoltaic module. The lamination layer may be arranged behind the translucent pane, in particular on the translucent pane. The lamination layer may be the most backside layer of the front pane, for example by being arranged on the backside of the front pane facing the photovoltaic layer. The lamination layer may be configured to allow for contacting the photovoltaic layer of the photovoltaic module. The lamination layer may be arranged behind the interference filter, in particular arranged on the back side of the interference filter, if the at least one interference layer is arranged behind the translucent pane.

In an embodiment of the front pane according to the first aspect, the colorant layer has an index of refraction that is equal to or larger than an index of refraction of the translucent pane. For example, the colorant layer may only have an index of refraction for a translucent portion of the colorant layer. For example, the index of refraction of the colorant layer may correspond to an index of refraction of the matrix. Opaque portions of the colorant layer, for example formed by the colored particles, may not allow light to pass therethrough, and are therefore not considered when determining the index of refraction of the colorant layer. Alternatively, the index of refraction of the colorant layer may be the highest index of any portion of the colorant layer or may be an average index of refraction of the colorant layer. For example, a translucent glass pane may have an index of refraction of about 1,6 while the colorant layer may have an index of refraction of about 1,65 to 1,75. By minimizing the difference in the index of refraction of the two adjacent materials, the total reflection of the solar spectrum may be reduced. A higher index of refraction for the colorant layer may allow the use of material more resistant to the elements.

In an embodiment of the front pane according to the first aspect, the front pane comprises a protective layer. The protective layer may be arranged as a most frontside layer of the front pane. For example, the protective layer may be configured as a plastic film. Alternatively the protective layer may be configured as a thin film consisting of at least 90% of one or more of the following SiO₂, TiO₂, or Al₂O₃. The protective layer may also feature anti-reflective or bio-catalytic properties. The protective layer may be bonded to a layer arranged underneath the protective layer. The protective layer may provide protection against the elements and/or mechanical damage, for example scratches. The protective layer may be an outermost layer of the front pane. The at least one interference layer may be a second outermost layer arranged directly underneath the protective layer. The protective layer may be more scratch resistant and/or thicker than the colorant layer and/or layers of the interference filter.

In an embodiment of the front pane according to the first aspect, the at least one interference layer is arranged in front of the translucent pane. Said arrangement facilitates handling of the front pane and subsequent manufacturing steps. For example, the at least one interference layer may be arranged directly on the front side of the translucent pane. Such an arrangement may be particular easy to manufacture. The interference filter may thus be at least partially formed in front of the translucent pane. For example, all the layers of the interference filter or even all layers except the translucent pane may be arranged in front of the translucent pane.

In an embodiment of the front pane according to the first aspect, the at least one interference layer is arranged behind the translucent pane. Said arrangement provides protection of the at least one interference layer, for example without requiring additional layers. The interference layer may thus be manufactured from a material that is not resistant to the elements without needing to be concerned about the durability of the front pane. For example, the at least one interference layer may be arranged directly on the back side of the translucent pane. The interference filter may thus be at least partially formed behind the translucent pane. For example, all layers of the interference filter, except the translucent pane if part of the interference filter, are arranged behind the translucent pane.

In an embodiment of the front pane according to the first aspect, the colorant layer is arranged in front of the translucent pane. For example, the colorant layer may be arranged directly on the front side of the translucent pane and/or the interference filter, in particular the at least one interference layer of the interference filter. Such an arrangement may be particular easy to manufacture.

In an embodiment of the front pane according to the first aspect, the colorant layer is arranged behind the translucent pane. For example, the colorant layer may be arranged directly on the back side of the translucent pane and/or the interference filter, in particular the at least one interference layer of the interference filter. Such an arrangement may protect the colorant layer from the elements. Colorant material that is not environment stable may thus be used without concerns about a durability of the front pane.

In an embodiment of the front pane according to the first aspect, the colorant layer is arranged in front of the interference filter, in particular on a front side of the at least one interference layer. Arranging the colorant layer in such a way may result in a more solid appearance of the front pane. Further, this may result in a particular low angle dependency of the overall color. Generally speaking, if the colorant layer is arranged more forward in the front pane, the overall color may be richer and/or the overall color may have a low angle dependency.

In an embodiment of the front pane according to the first aspect, wherein the colorant layer is arranged behind the interference filter, in particular on a back side of the at least one interference layer. Such an arrangement may provide an appearance with more visual depths, allowing a design with a different appearance to conventional building materials such as metal or concrete.

Further, the colorant layer may allow bonding of interference layer material that would not adhere to the translucent pane, allowing a broader choice of materials. Alternatively, the colorant layer may not be arranged between interference layers. For example, the interference layers may all be directly arranged on each other without further layers between those interference layers.

When the position of the at least one interference layer is described herein, it may equally relate in some embodiments to all interference layers and thus the complete interference filter. For example, if the at least interference filter is described as arranged in front of the translucent pane, all interference layers and thus the interference filter may be arranged in front of the translucent pane. Similarly and also for example, if the at least interference filter is described as arranged behind the colorant layer, all interference layers and thus the interference filter may be arranged behind the colorant layer.

In an embodiment of the front pane according to the first aspect, the colorant layer and the at least one interference layer are arranged directly on each other. Alternatively, the colorant layer and the interference filter are spaced apart by another layer, in particular the translucent pane. For example, the at least one interference layer may be arranged on a side of the translucent pane opposite the colorant layer. The colorant layer may not be in contact with layers of the interference filter besides the translucent pane, if part of the interference filter. Such a configuration allows material selection of the colorant layer and the at least one interference layer independently of each other.

In an embodiment of the front pane according to the first aspect, the at least one interference layer is arranged in front of the translucent pane and the colorant layer is arranged in front of the at least one interference layer. The colorant layer is thus arranged in front of the translucent pane. The colorant layer may be arranged in front of any other layer of the interference filter, for example on the at least one interference layer. With such an arrangement, the front pane may have a very solid frontal appearance and may be easy to manufacture and handle.

In an embodiment of the front pane according to the first aspect, the at least one interference layer is arranged in front of the translucent pane, the colorant layer is arranged in front of the translucent pane and the colorant layer is arranged behind the at least one interference layer. Such an arrangement allows a broader choice of materials for the different layers. In particular, the colorant layer may be treated, in particular heat treated, before application of the at least one interference layer so that the interference layer does not need to be able to withstand such a treatment as well.

In an embodiment of the front pane according to the first aspect, the at least one interference layer is arranged behind the translucent pane and the colorant layer is arranged behind the at least one interference layer. The colorant layer is thus arranged behind the translucent pane. Such an arrangement may result in a particular robust front pane. In addition, bonding with the photovoltaic layer may be facilitated, for example with the lamination layer. Such bonding does not have the risk of damaging the at least one interference layer, which may be less robust than the colorant layer. Further, the at least one interference layer may be directly applied to the translucent pane. The colorant layer may be arranged behind the interference filter. For example, the translucent pane may be the outermost layer.

In an embodiment of the front pane according to the first aspect, the at least one interference layer is arranged behind the translucent pane, the colorant layer is arranged behind the translucent pane and the colorant layer is arranged in front of the at least one interference layer. The colorant layer is thus arranged between the at least one interference layer and the translucent pane. Such an arrangement provides a very durable front pane. In addition, the colorant layer may again be treated before the at least one interference layer is applied. For example, the translucent pane may again be the outermost layer.

In an embodiment of the front pane according to the first aspect, the at least one interference layer is arranged behind the translucent pane and the colorant layer is arranged in front of the translucent pane. The colorant layer may provide protection for the translucent pane in such a configuration. Further, the at least one interference layer and the colorant layer may be applied independently so that order of application and treatment steps may be chosen independently, as is most suitable for the used materials. The colorant layer is thus arranged in front of the at least one interference layer but not on the at least one interference layer in this arrangement.

In an embodiment of the front pane according to the first aspect, the at least one interference layer is arranged in front of the translucent pane and the colorant layer is arranged behind the translucent pane. Such an arrangement may provide an appearance with depth, in which a viewer can see that the front pane is layered. Further, the at least one interference layer and the colorant layer may again be applied independently so that order of application and treatment steps may be chosen independently, as is most suitable for the used materials. The colorant layer is thus arranged behind the at least one interference layer in this arrangement. Such an arrangement may result in less absorption of light by the colorant layer since the interference filter may reflect some light before it reaches the colorant layer.

The front pane may consist of the layers mentioned above. Alternatively, the front pane may comprise additional layers. The front pane may have additional layers just on the front side or back side of the layers mentioned above. The front pane may thus be free of layers arranged in between the layers with an arrangement as described above. Alternatively, additional layers may be arranged between the layers mentioned above. Layers may be bonded by an adhesive, which may be considered as an additional layer or part of the layers thus bonded. The front pane may also be free of glue bonding the above-mentioned layers.

A second aspect relates to a photovoltaic module comprising a photovoltaic layer and a front pane according to the first aspect. The photovoltaic module may comprise means for mounting, such as a frame or other fixture that can be integrated into an exterior of a building, in particular its fagade. The photovoltaic module may comprise additional means required for generating electricity from sunlight, such as an inverter and/or electrical contacts. Preferred embodiments and expedient developments of the first aspect may also constitute preferred embodiments and expedient developments of the second aspect. The photovoltaic layer may be arranged at a back side of the front pane. For example, the photovoltaic layer may comprise at least one crystalline silicone solar cell.

In an embodiment of the photovoltaic module according to the second aspect, the photovoltaic module comprises a back pane arranged at a side of the photovoltaic layer opposite a side facing the front pane. The front pane and the back pane can encapsulate the photovoltaic layer and optionally other components of the photovoltaic module. The back pane may comprise a substrate. For example, the substrate may be a metallic, plastic or glass sheet. The back pane may consist of the substrate or comprise additional layers. The back pane may further support and protect the photovoltaic layer.

In an embodiment of the photovoltaic module according to the second aspect, the back pane comprises a lamination layer and a substrate, wherein the lamination layer is arranged between the substrate and the photovoltaic layer. The lamination layer may facilitate bonding with the photovoltaic layer and/or may provide additional environmental protection for the photovoltaic layer.

In an embodiment of the photovoltaic module according to the second aspect, the photovoltaic module is configured for integration into a building, in particular into a façade of the building. For example, the photovoltaic module may partially form an exterior of the building and may be configured to extend substantially vertically when mounted to the building. The photovoltaic module may be configured for vertical mounting. Due to the colorant layer and interference filter in the front pane, the photovoltaic module may be very efficient while still easily satisfying the design needs of architects. The photovoltaic module may also be configured for an inclined or horizontal mounting. In such a configuration, the photovoltaic module may be arranged on the roof of the building or the ground, such as on a field.

### Item list

In the following, possible features and feature combinations of the two aspects are presented as a list of items, which forms part of the present disclosure:
1. Front pane for a photovoltaic module comprising
   a translucent, in particular transparent, pane with a front side facing outwardly in the photovoltaic module and a back side facing towards a photovoltaic layer of the photovoltaic module,
   an interference filter configured to provide a base color for the front pane, the interference filter comprising at least one interference layer, and
   a colorant layer configured to provide a color modification for the front pane so that an overall color of the front pane is different to the base color and a color of the colorant layer.
2. Front pane according to item 1,
   wherein the interference filter is configured as a multilayer filter,
   in particular
   with layers of different materials
      and/or
   with layers of different refractive indices.
3. Front pane according to item 1 or 2,
   wherein at least one of the sides of the translucent pane has a structured surface and/or
   wherein at least one of the sides of the translucent pane has a flat surface and/or
   wherein the translucent pane is configured as a glass pane, in particular a fully tempered or semi tempered glass,
      and/or
   wherein the translucent pane provides structural support for the front pane and/or
   wherein the translucent pane is essentially colorless.
4. Front pane according to any one of the preceding items,
   wherein the colorant layer comprises colored particles, in particular colored inorganic particles.
5. Front pane according any one of the preceding items,
   wherein the interference layer leads to an average transmissive loss between 1% and 25% of an incoming light spectrum, in particular between 3% and 15%, and/or
   the colorant layer leads to an average transmissive loss between 2% and 60% of the incoming light spectrum, in particular between 5% and 45%.
6. Front pane according to any one of the preceding items,
   wherein the front pane comprises a lamination layer, in particular configured as a film,
   wherein the lamination layer is arranged behind the translucent pane
      and/or
   wherein the lamination layer is configured for contacting the photovoltaic layer of the photovoltaic module.
7. Front pane according to any one of the preceding items,
   wherein the colorant layer has an index of refraction that is equal to or larger than an index of refraction of the translucent pane
8. Front pane according to any one of the preceding items,
   wherein the front pane comprises a protective layer arranged as a most frontside layer of the front pane.
9. Front pane according to any one of the preceding items,
   wherein the at least one interference layer is arranged in front of the translucent pane
      or
   wherein the at least one interference layer is arranged behind the translucent pane.
10. Front pane according to any one of the preceding items,
   wherein the colorant layer is arranged in front of the translucent pane
      or
   wherein the colorant layer is arranged behind the translucent pane.
11. Front pane according to any one of the preceding items,
   wherein the colorant layer is arranged in front of the interference filter, in particular on a front side of the at least one interference layer,
      or
   wherein the colorant layer is arranged behind the interference filter, in particular on a back side of the at least one interference layer,
      or
   wherein the colorant layer is arranged between the layers of the interference filter.
12. Front pane according to any one of the preceding items,
   wherein the colorant layer and the at least one interference layer are arranged directly on each other
      or
   wherein the colorant layer and the interference filter are spaced apart by another layer, in particular the translucent pane.
13. Front pane according to any one of the preceding items,
   wherein the at least one interference layer is arranged in front of the translucent pane and
   wherein the colorant layer is arranged in front of the at least one interference layer.
14. Front pane according to any one of the preceding items 1 to 12,
   wherein the at least one interference layer is arranged in front of the translucent pane,
   wherein the colorant layer is arranged in front of the translucent pane and wherein the colorant layer is arranged behind the at least one interference layer.
15. Front pane according to any one of the preceding items 1 to 12,
   wherein the at least one interference layer is arranged behind the translucent pane and
   wherein the colorant layer is arranged behind the at least one interference layer.
16. Front pane according to any one of the preceding items 1 to 12,
   wherein the at least one interference layer is arranged behind the translucent pane,
   wherein the colorant layer is arranged behind the translucent pane and
   wherein the colorant layer is arranged in front of the at least one interference layer.
17. Front pane according to any one of the preceding items 1 to 12,
   wherein the at least one interference layer is arranged behind the translucent pane and
   wherein the colorant layer is arranged in front of the translucent pane.
18. Front pane according to any one of the preceding items 1 to 12,
   wherein the at least one interference layer is arranged in front of the translucent pane and
   wherein the colorant layer is arranged behind the translucent pane.
19. Photovoltaic module comprising a photovoltaic layer, in particular comprising at least one crystalline silicone solar cell, and a front pane according to any one of the preceding claims,
   wherein the photovoltaic layer is arranged at a back side of the front pane.
20. Photovoltaic module according to item 19,
   wherein the photovoltaic module comprises a back pane arranged at a side of the photovoltaic layer opposite a side facing the front pane.
21. Photovoltaic module according to item 20,
   wherein the back pane comprises a lamination layer and a substrate, wherein the lamination layer is arranged between the substrate and the photovoltaic layer.
22. Photovoltaic module according to any one of items 19 to 21,
   wherein the photovoltaic module is configured for integration into a building, in particular into a façade of the building.

Further features of the present invention will be apparent from consideration of the information contained above as well as in or in combination with the following detailed description, drawings and claims. The present invention is illustrated by way of example, and not by way of limitation, in the figures of the accompanying drawings.

### Brief Description of the Drawings

- Fig. 1: schematically illustrates a first embodiment of a front pane for a photo-voltaic module.
- Fig. 2: schematically illustrates a second embodiment of a front pane for a photovoltaic module.
- Fig. 3: schematically illustrates a third embodiment of a front pane for a photo-voltaic module.
- Fig. 4: schematically illustrates a fourth embodiment of a front pane for a photo-voltaic module.
- Fig. 5: schematically illustrates a fifth embodiment of a front pane for a photo-voltaic module.
- Fig. 6: schematically illustrates a sixth embodiment of a front pane for a photo-voltaic module.

### Detailed Description of Embodiments

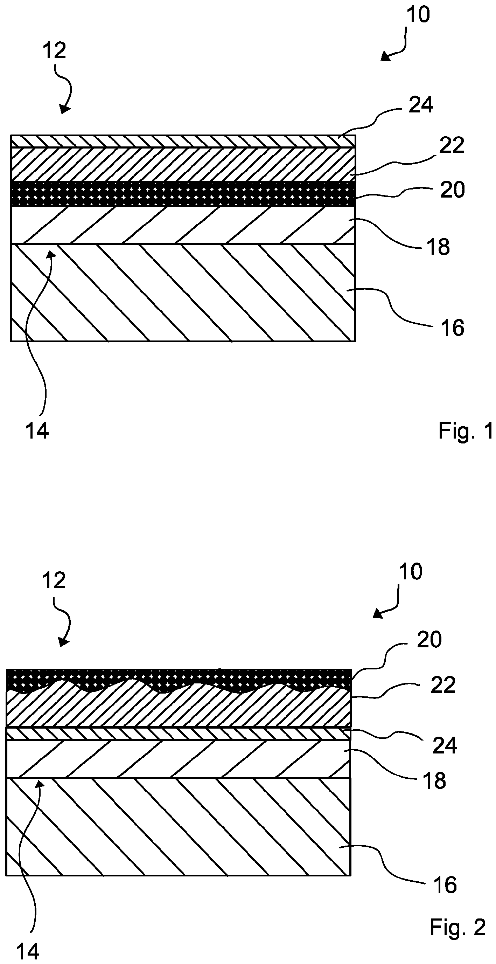

Fig. 1 illustrates a section of a first embodiment of a front pane 10 of a photovoltaic module. The front pane 10 has a flat sheet form with a front side 12 and a back side 14. A front side and a back side of each layer of the front pane 10 faces in the same direction as the overall front side 12 and back side 14 of the front pane 10. The front pane 10 covers a photovoltaic layer 16 of the photovoltaic module. The photovoltaic layer 16 is attached to the back side of the front pane 10 via a lamination layer 18. The lamination layer 18 forms the backmost layer of the front pane 10. In Fig. 1, the lamination layer 18 is arranged directly on the back side of a colorant layer 20. The lamination layer 18 may optionally encapsulate the photovoltaic layer 16. The colorant layer 20 comprises colored particles of an inorganic material such as a ceramic material. The colored particles are configured to absorb and/or reflect light at a certain spectrum. The colorant layer 20 is a layer, for example configured as glass enamel with colored particles embedded therein occluding 10% of the surface. The particles may be completely opaque if not covering the complete surface. Alternatively, the colorant layer 20 may comprise a different matrix with the colored particles embedded therein. As a further alternative, the colorant layer may consist of the colored particles. Said colored particles may form a continuous layer or may be arranged spaced apart without a matrix. A spacing and size of the particles may be chosen to provide the appearance of a continuous layer beyond a minimum distance. The colorant layer 20 is arranged directly on the back side of a translucent pane 22. The translucent pane 22 is configured as a sheet of, for example, tempered silicate glass. The translucent pane 22 provides structural support for the front pane 10. At least one interference layer 24 is arranged directly on the front side of the translucent pane 22. The interference filter may comprise additional interference layers, each of which may for example be arranged on the front side of the translucent pane. The interference filter may be configured as a multilayer filter.

As can be taken from the above, in the first embodiment of the front pane 10, the at least one interference layer 24 is arranged in front of the translucent pane 22 and the colorant layer 20 is arranged behind the translucent pane 22. Such an arrangement may be particular easy to handle during manufacturing and installation in the photovoltaic module.

The translucent, presently transparent, pane 22 is facing with its front side outwardly in the photovoltaic module and with its back side towards the photovoltaic layer 16 of the photovoltaic module. The interference filter is configured to provide a base color for the front pane 10. The colorant layer 20 is configured to provide a color modification for the front pane 10 so that an overall color of the front pane 10 is different to the base color and a color of the colorant layer 20. Overall, the front pane 10 thus has a high transmissivity and a low change in color appearance depending on a viewing angle. Further, the front pane 10 may have a wider range of colors than a front pane either just having an interference filter or a colorant layer.

The translucent pane 22 both has a flat front and back surface in the first embodiment. The translucent pane 22 is, for example, manufactured in a float glass process. The translucent pane 22 is essentially colorless. The front pane of Fig. 1 may comprise an additional protective layer 26 as the front most layer on top of the at least one interference layer 24. In the example shown in Fig. 1, the at least one interference layer 24 is forming the front most layer of the front pane 10. The lamination layer 18 is forming the back most layer of the front pane 10.

Fig. 2 illustrates a section of a second embodiment of a front pane 10 of a photovoltaic module. The second embodiment is similar to the first embodiment and only differences will be discussed herein. In particular, the second embodiment has a different order of layers. In the second embodiment, the at least one interference layer 24 is arranged behind the translucent pane 22 and the colorant layer 20 is arranged in front of the translucent pane 22. The at least one interference layer 24 is thus arranged on top of the lamination layer 18 and directly on the back side of the translucent pane 22. The colorant layer 20 is arranged directly on the front side of the translucent pane 22 and forms the top most or outer most layer in the second embodiment. The colorant layer 20 may be configured to provide protection to layers arranged underneath if arranged as the top most layer. For example, such protection can be provided when the colorant layer 20 comprises fused glass frit. Optionally, the second embodiment may also comprise the protective layer 26 as the outer most layer. In the second embodiment, the colorant layer 20 is arranged outside. The colorant layer 20 may be more robust than the at least one interference layer 24, resulting in a more robust front pane 10, in particular if no additional protective layer 26 is provided.

Further, the front side of the translucent pane 22 has a structured surface. The front side may, for example, be structured with a post-glass production acid or laser treatment. Alternatively, the surface may be structured during the glass production process, for example through structured rollers indenting the glass surface. The structured surface may reduce glare due to light reflection. Alternatively or additionally, the structured surface may increase light collected and transmitted to the photovoltaic layer 16. Alternatively or additionally, the structured surface may reduce viewing angle dependency of the overall color of the front pane 10.

In a further embodiment, a back side of the translucent pane 22 may have a structured surface. Such a structured back side may be provided alternatively or additionally to the structured front side.

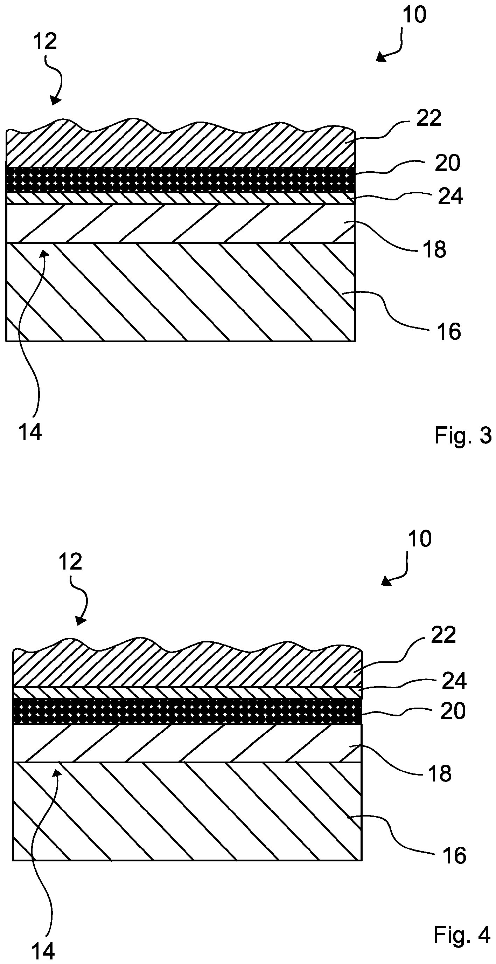

Fig. 3 illustrates a section of a third embodiment of a front pane 10 of a photovoltaic module. The third embodiment is similar to the second embodiment. Differences will be discussed herein. In particular, the third embodiment has a different order of layers. In the third embodiment, the at least one interference layer 24 is arranged behind the translucent pane 22, the colorant layer 20 is arranged behind the translucent pane and the colorant layer 20 is arranged in front of the at least one interference layer 24. In such a configuration, the translucent pane 22 provides protection for the colorant layer 20 and the at least one interference layer 24. Overall color appearance may be more solid so that the front pane 10 gives the impression of having a non-see-through backside. Similar to the second embodiment, the front side of the translucent pane 22 is also structured in the third embodiment. Such a structure may improve protection from the elements, such as from UV beams and generally the weather. Besides a reduction in angle dependency, the structure may also reduce glare and/or facilitate providing an anti-reflection layer on the front side.

Fig. 4 illustrates a section of a fourth embodiment of a front pane 10 of a photovoltaic module. The fourth embodiment is similar to the third embodiment and only differences will be discussed herein. In particular, the fourth embodiment has a different order of layers. The at least one interference layer 24 is arranged behind the translucent pane 22 and the colorant layer 20 is arranged behind the at least one interference layer 24. Such a configuration may provide a front pane 10 with a more depth-like appearance. Further, a lamination layer may adhere particularly well to the back side with such a configuration.

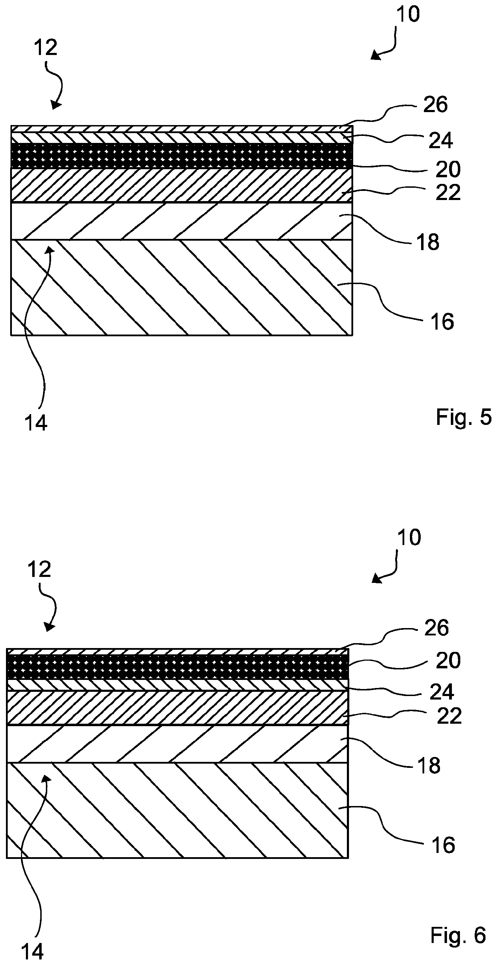

Fig. 5 illustrates a section of a fifth embodiment of a front pane 10 of a photovoltaic module. The fifth embodiment is similar to the first embodiment. Differences will be discussed herein. Similar to the first embodiment, both sides of the translucent pane 22 are flat in the fifth embodiment. The fifth embodiment also comprises the optional protective layer 26, which may optionally be included in the other embodiments as well.

Otherwise, the fifth embodiment has a different order of layers. The at least one interference layer 24 is arranged in front of the translucent pane 22, the colorant layer 20 is arranged in front of the translucent pane 22 and the colorant layer 20 is arranged behind the at least one interference layer 24. Such an arrangement allows heat treatment of the colorant layer 20 before applying the at least one interference layer.

Fig. 6 illustrates a section of a sixth embodiment of a front pane 10 of a photovoltaic module. The sixth embodiment is similar to the fifth embodiment and only differences will be discussed herein. In particular, the sixth embodiment has a different order of layers. The at least one interference layer 24 is arranged in front of the translucent pane 22 and the colorant layer 20 is arranged in front of the at least one interference layer 24. The colorant layer 20 may thus provide additional mechanical protection to the at least one interference layer 20, in addition to the protective layer 26. Furthermore, this embodiment may feature a particularly low dependency of the color impression on the viewing angle.

### List of Reference Signs

- 10: front pane
- 12: front side
- 14: backside
- 16: photovoltaic layer
- 18: lamination layer
- 20: colorant layer
- 22: translucent pane
- 24: interference layer
- 26: protective layer

## Claims

1. Front pane (10) for a photovoltaic module comprising
a translucent, in particular transparent, pane (22) with a front side facing outwardly in the photovoltaic module and a back side facing towards a photovoltaic layer (16) of the photovoltaic module,
an interference filter configured to provide a base color for the front pane (10), the interference filter comprising at least one interference layer (24), and
a colorant layer (20) configured to provide a color modification for the front pane (10)
so that an overall color of the front pane (10) is different to the base color and a color of the colorant layer (20).

2. Front pane (10) according to claim 1,
wherein the interference filter is configured as a multilayer filter,
in particular
with layers of different materials
and/or
with layers of different refractive indices.

3. Front pane (10) according to claim 1 or 2,
wherein at least one of the sides of the translucent pane (22) has a structured surface
and/or
wherein at least one of the sides of the translucent pane (22) has a flat surface and/or
wherein the translucent pane (22) is configured as a glass pane, in particular a fully tempered or semi tempered glass,
and/or
wherein the translucent pane (22) provides structural support for the front pane (10)
and/or
wherein the translucent pane (22) is essentially colorless.

4. Front pane (10) according to any one of the preceding claims,
wherein the colorant layer (20) comprises colored particles, in particular colored inorganic particles.

5. Front pane (10) according to any one of the preceding claims,
wherein the interference layer (24) leads to an average transmissive loss between 1% and 25% of an incoming light spectrum, in particular between 3% and 15%, and/or
the colorant layer (20) leads to an average transmissive loss between 2% and 60% of the incoming light spectrum, in particular between 5% and 45%.

6. Front pane (10) according to any one of the preceding claims,
wherein the colorant layer has an index of refraction that is equal to or larger than an index of refraction of the translucent pane.

7. Front pane (10) according to any one of the preceding claims,
wherein the front pane (10) comprises a protective layer (26) arranged as a most frontside layer of the front pane (10).

8. Front pane (10) according to any one of the preceding claims,
wherein the colorant layer (20) and the at least one interference layer (24) are arranged directly on each other
or
wherein the colorant layer (20) and the interference filter are spaced apart by another layer, in particular the translucent pane (22).

9. Front pane (10) according to any one of the preceding claims 1 to 8,
wherein the at least one interference layer (24) is arranged in front of the translucent pane (22),
wherein the colorant layer (20) is arranged in front of the translucent pane (22) and wherein the colorant layer (20) is arranged behind the at least one interference layer (24).

10. Front pane (10) according to any one of the preceding claims 1 to 8,
wherein the at least one interference layer (24) is arranged in front of the translucent pane (22), and
wherein the colorant layer (20) is arranged in front of the at least one interference layer (24).

11. Front pane (10) according to any one of the preceding claims 1 to 8,
wherein the at least one interference layer (24) is arranged behind the translucent pane (22),
wherein the colorant layer (20) is arranged behind the translucent pane (22) and wherein the colorant layer (20) is arranged in front of the at least one interference layer (24).

12. Front pane (10) according to any one of the preceding claims 1 to 8,
wherein the at least one interference layer (24) is arranged behind the translucent pane (22) and
wherein the colorant layer (20) is arranged in front of the translucent pane (22).

13. Front pane (10) according to any one of the preceding claims 1 to 8,
wherein the at least one interference layer (24) is arranged in front of the translucent pane (22) and
wherein the colorant layer (20) is arranged behind the translucent pane (22).

14. Photovoltaic module comprising a photovoltaic layer (16), the photovoltaic layer (16) in particular comprising at least one crystalline silicone solar cell, and a front pane (10) according to any one of the preceding claims,
wherein the photovoltaic layer (16) is arranged at a back side of the front pane (10).

15. Photovoltaic module according claim 14,
wherein the photovoltaic module is configured for integration into a building, in particular into a façade of the building.
